(19) Europäisches Patentamt / European Patent Office / Office européen des brevets

(11) **EP 2 762 313 B1**

(12) **EUROPEAN PATENT SPECIFICATION**

(45) Date of publication and mention of the grant of the patent:
**24.07.2019 Bulletin 2019/30**

(51) Int Cl.:
***B41N 1/00*** *(2006.01)*     ***B41C 1/02*** *(2006.01)*
***G02F 1/1333*** *(2006.01)*

(21) Application number: **12836962.6**

(22) Date of filing: **27.09.2012**

(86) International application number:
**PCT/KR2012/007799**

(87) International publication number:
**WO 2013/048133 (04.04.2013 Gazette 2013/14)**

(54) **CLICHE FOR OFFSET-PRINTING AND METHOD FOR MANUFACTURING SAME**

KLISCHEE ZUM OFFSETDRUCKEN UND HERSTELLUNGSVERFAHREN DAFÜR

PLAQUE D'IMPRESSION OFFSET ET SON PROCÉDÉ DE PRODUCTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.09.2011 KR 20110097755**

(43) Date of publication of application:
**06.08.2014 Bulletin 2014/32**

(73) Proprietor: **LG Chem, Ltd.**
**Seoul 150-721 (KR)**

(72) Inventors:
• **HWANG, Ji Young**
**Daejeon 302-150 (KR)**

• **KOO, Beom Mo**
**Daejeon 305-509 (KR)**

(74) Representative: **Goddar, Heinz J. et al**
**Boehmert & Boehmert**
**Anwaltspartnerschaft mbB**
**Pettenkoferstrasse 22**
**80336 München (DE)**

(56) References cited:
**JP-A- 2008 142 956**    **KR-A- 20090 119 358**
**KR-A- 20100 009 919**    **KR-A- 20100 035 626**
**KR-A- 20110 069 459**    **KR-B1- 100 606 441**
**US-A1- 2005 243 233**    **US-A1- 2009 283 000**
**US-A1- 2011 132 527**

## Description

[Technical Field]

The present invention relates to a cliché for offset printing and a method of manufacturing the same, and more particularly, to a cliché for offset printing having various line widths and etching depths in order to control a bottom touch phenomenon occurring due to an increase in line width to be implemented when the cliché is manufactured by single etching, and a method of manufacturing the same.

[Background Art]

In the manufacture of a flat panel display (FPD) such as a liquid crystal display (LCD) or a plasma display panel (PDP), processes for forming various kinds of patterns such as electrodes or black matrix, color filters, separators, thin film transistors and the like are required.

As the pattern forming process, a method for forming a pattern by using a photosensitive resist and a photomask to obtain a photosensitive resist pattern which is selectively removed through exposure and development and using the same has been frequently used. The photomask process has a problem in that a material such as photosensitive resist or developing solution is often used, an expensive photomask needs to be used, and many processing steps need to be performed or the process time is prolonged.

In order to solve the problem, there have been proposed methods for printing a pattern-forming material directly, such as a method by inkjet printing or laser transfer, without using a photosensitive resist. As one of the methods, there is an offset printing method in which a patterned material is transferred to a blanket using a cliché and then the pattern of the blanket is transferred to a substrate.

The offset printing method using a cliché is advantageous in that the material consumption is less and the process is simpler than a method in the related art using a photosensitive resist and the process speed is faster than inkjet printing or laser transfer. However, the offset printing method is disadvantageous in that clichés are needed respectively for substrates with different patterns and manufacturing clichés usually made of glass is a complicated and expensive process. In the case of a known cliché (the case of reverse offset and gravure offset), manufacturing adopting a single etching method after patterning is a general method of manufacturing the cliché, and in the case where this manufacturing method is used, there is a disadvantage in that a problem of bottom touch occurs when the wide pattern is implemented due to printing pressure and roughness of the blanket in printing.

Accordingly, in the related art, an effort of hatching a line width corresponding to a wide region by a fine line has been made in order to solve this problem or an effort of solving the problem has been made through a dry etching process, but in these cases, similarly, a problem of a loss of desired conductivity occurs in the case of fine line hatching, and a problem of an increase in manufacturing cost occurs in the case where the dry etching process is used.

KR20110069459 relates to a printing plate which can prevent that the printing roller contacts to the floor of the printing plate and manufacturing method thereof and method of manufacturing thin film pattern using that.

US2011/0132527 discloses a method for fabricating a cliché comprising the steps of: providing a base substrate having first and second regions; forming a first depressed pattern having a first depth and a first width at a first region, and a second depressed pattern having a second width greater than the first width and a depth the same with the first depth at a second region; forming a protective film for exposing the second region and covering the first region, the protective film having adhesivity; forming the second depressed pattern to have a second depth deeper than the first depth of the first depressed pattern at the first region by using the protective film having the adhesivity; and removing the protective film.

US2005/0243233 discloses a method for fabricating a cliché comprising: providing a transparent glass substrate; depositing a metal layer on the substrate; pattering the layer to form a first metal pattern, etching the glass substrate using the first metal pattern as a mask, thereby forming a first convex pattern; pattering the first metal pattern to form a second metal pattern; and etching the first convex pattern using the second metal pattern as a mask, thereby forming a second convex pattern.

[Disclosure]

[Technical Problem]

Therefore, the present invention has been made in an effort to provide a cliché for offset printing, which can solve a bottom touch phenomenon occurring according to an increase in line width to be implemented when the cliché is manufactured by single etching and has various line widths and etching depths, and a method of manufacturing the same.

[Technical Solution]

An exemplary embodiment of the present invention provides a cliché for offset printing comprising: a groove pattern, wherein a depth of at least a partial region of the groove pattern is different from a depth of a residual region, the cliché for offset printing comprises the groove pattern of a linear pattern and the groove pattern of a closed figure,

the groove pattern of a linear pattern satisfies the following Relationship Equation 1, and the groove pattern of a closed figure satisfies the following Relationship Equa-

tion 2:

[Relationship Equation 1]

$$D \geq 42.9\exp(-\{(P - W)/P\}/0.35) - 1.5$$

wherein D is the depth of the groove pattern, P is a pitch, W is the line width of the groove pattern, and all of units thereof are micrometers,

[Relationship Equation 2]

$$D \geq 33.8\exp(-\{(P - W)/P\}/0.235) + 0.82$$

wherein D is the depth of the groove pattern, P is the pitch, W is the line width of the groove pattern, and all of units thereof are micrometers.

Another exemplary embodiment of the present invention provides a method of manufacturing a cliché for offset printing, comprising: 1) forming a first mask pattern on a substrate, 2) forming a second mask pattern on the substrate and the first mask pattern, 3) etching the substrate by using the second mask pattern, 4) removing the second mask pattern, and 5) etching the substrate by using the first mask pattern in an etching depth that is different from an etching depth of step 3), wherein a groove pattern formed by etching of step 3) and a groove pattern formed by etching of step 5) comprises a linear pattern and a closed figure, the groove pattern of a linear pattern satisfies the following Relationship Equation 1, and the groove pattern of a closed figure satisfies the following Relationship Equation 2:

[Relationship Equation 1]

$$D \geq 42.9\exp(-\{(P - W)/P\}/0.35) - 1.5$$

wherein D is the depth of the groove pattern, P is a pitch, W is the line width of the groove pattern, and all of units thereof are micrometers,

[Relationship Equation 2]

$$D \geq 33.8\exp(-\{(P - W)/P\}/0.235) + 0.82$$

wherein D is the depth of the groove pattern, P is the pitch, W is the line width of the groove pattern, and all of units thereof are micrometers.

Yet another exemplary embodiment of the present invention provides a method of manufacturing a cliché for offset printing, comprising: 1) forming a first mask pattern on a substrate, 2) forming a front surface layer for a second mask pattern on the substrate and the first mask pattern, 3) forming a third mask pattern on the front surface layer for the second mask pattern, 4) forming the second mask pattern by using the third mask pattern, 5) etching the substrate by using the second mask pattern, 6) removing the second mask pattern, and 7) etching the substrate by using the first mask pattern in an etching depth that is different from an etching depth of step 5), wherein a groove pattern formed by etching of step 5) and a groove pattern formed by etching of step 7) comprises a linear pattern and a closed figure, the groove pattern of a linear pattern satisfies the following Relationship Equation 1, and the groove pattern of a closed figure satisfies the following Relationship Equation 2:

[Relationship Equation 1]

$$D \geq 42.9\exp(-\{(P - W)/P\}/0.35) - 1.5$$

wherein D is the depth of the groove pattern, P is a pitch, W is the line width of the groove pattern, and all of units thereof are micrometers,

[Relationship Equation 2]

$$D \geq 33.8\exp(-\{(P - W)/P\}/0.235) + 0.82$$

wherein D is the depth of the groove pattern, P is the pitch. W is the line width of the groove pattern, and all of units thereof are micrometers.

Provided is a printed matter printed by using the cliché.

Provided js a touch panel comprising: the printed matter.

[Advantageous Effects]

The present invention may comprise a double etching process when a cliché for offset printing is manufactured to control a bottom touch phenomenon that is a problem exhibited when a known wide line width is implemented, thus manufacturing the cliché for offset printing having various line widths and etching depths.

[Brief Description of the Drawings]

FIG. 1 is a view showing the Relationship Equation of an etching depth and a final etching line width according to an initial patterning line width during a single etching process.
FIG. 2 is a view showing a result of bottom touch of a linear pattern in a printing direction of a cliché for offset printing with regard to various etching depths during the single etching process.
FIG. 3 is a view showing a result of bottom touch of a square pattern of the cliché for offset printing with regard to various etching depths during the single etching process.

FIG. 4 is a view schematically showing a process of manufacturing a cliché for offset printing according to an exemplary embodiment of the present invention.

FIG. 5 is a view showing a microscope picture of the cliché for offset printing according to the exemplary embodiment of the present invention and a printed matter using the same.

FIG. 6 is a view showing an electronic microscope picture of a cross-section of the cliché for offset printing according to the exemplary embodiment of the present invention.

FIG. 7 is a view showing a relative difference in transmission by HF in the case where only Cr is present and in the case where CrOx is present.

[Best Mode]

Hereinafter, the present invention will be described in detail.

The present invention provides a cliché for offset printing, which can control a bottom touch phenomenon that is a problem exhibited when a known wide line width is implemented and has various line widths and etching depths, and the cliché for offset printing according to the present invention comprises a groove pattern, wherein a depth of at least a partial region of the groove pattern is different from a depth of a residual region, the cliché for offset printing comprises the groove pattern of a linear pattern and the groove pattern of a closed figure, the groove pattern of a linear pattern satisfies the following Relationship Equation 1, and the groove pattern of a closed figure satisfies the following Relationship Equation 2:

[Relationship Equation 1]

$$D \geq 42.9\exp(-\{(P - W)/P\}/0.35) - 1.5$$

wherein D is the depth of the groove pattern, P is a pitch, W is the line width of the groove pattern, and all of units thereof are micrometers,

[Relationship Equation 2]

$$D \geq 33.8\exp(-\{(P - W)/P\}/0.235) + 0.82$$

wherein D is the depth of the groove pattern, P is the pitch, W is the line width of the groove pattern, and all of units thereof are micrometers..

In the cliché for offset printing according to the present invention, the regions having different depths of the groove pattern may comprise regions having different line widths of the groove pattern. In order to prevent occurrence of the bottom touch phenomenon of the cliché, it is preferable that the region having the relatively larger line width of the groove pattern comprise the region having the larger depth as compared to the region having the relatively smaller line width.

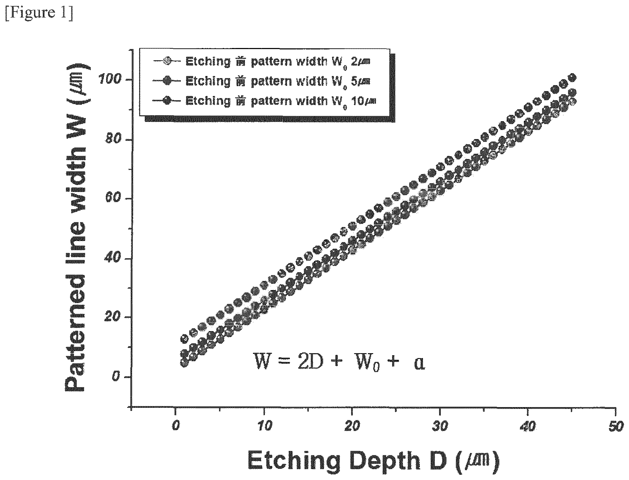

As shown in FIG. 1, in the case of the single etching, a minimum line width W may be determined by the Relationship Equation of a patterning line width W0 and an etching depth D before etching, and it is possible to perform printing without bottom touch only in the case where the line width W corresponds to a printing-enable region of the graph. Therefore, in the case of the single etching, printing-enable line width and pitch are limited according to the etching depth. In order to overcome this, in the present invention, the cliché having various etching depths and line widths may be manufactured by introducing a double etching process, and a printed matter having various line widths and pitches using the same may be formed.

In the cliché for offset printing according to the present invention, the groove pattern may comprise at least two patterns having different line widths simultaneously, and a difference between the line widths of at least two patterns may be 15 $\mu$m or more. At least two patterns where the difference between the line widths is 15 $\mu$m or more may be connected to each other. That is, the groove pattern may comprise a pattern where the region of the minimum line width and the region of the new line width formed through a double etching process are connected.

In the cliché for offset printing according to the present invention, the groove pattern may comprise two or more patterns where the difference between the line widths is 15 $\mu$m or more, and the groove pattern may further comprise a pattern having the line width that is different from the minimum line width by 500 $\mu$m or more.

In the cliché for offset printing according to the present invention, an align key may be further comprised in the region where the groove pattern of the cliché for offset printing is not provided.

Further, the exemplary embodiment of a method of manufacturing a cliché for offset printing according to the present invention comprises 1) forming a first mask pattern on a substrate, 2) forming a second mask pattern on the substrate and the first mask pattern, 3) etching the substrate by using the second mask pattern, 4) removing the second mask pattern, and 5) etching the substrate by using the first mask pattern in an etching depth that is different from an etching depth of step 3), wherein a groove pattern formed by etching of step 3) and a groove pattern formed by etching of step 5) comprises a linear pattern and a closed figure,

the groove pattern of a linear pattern satisfies the following Relationship Equation 1, and the groove pattern of a closed figure satisfies the following Relationship Equation 2:

[Relationship Equation 1]

$$D \geq 42.9\exp(-\{(P - W)/P\}/0.35) - 1.5$$

wherein D is the depth of the groove pattern, P is a pitch, W is the line width of the groove pattern, and all of units thereof are micrometers,

[Relationship Equation 2]

$$D \geq 33.8\exp(-\{(P - W)/P\}/0.235) + 0.82$$

wherein D is the depth of the groove pattern, P is the pitch, W is the line width of the groove pattern, and all of units thereof are micrometers. Further, another exemplary embodiment of a method of manufacturing a cliché for offset printing according to the present invention comprises 1) forming a first mask pattern on a substrate, 2) forming a front surface layer for a second mask pattern on the substrate and the first mask pattern, 3) forming a third mask pattern on the front surface layer for the second mask pattern, 4) forming the second mask pattern by using the third mask pattern, 5) etching the substrate by using the second mask pattern, 6) removing the second mask pattern, and 7) etching the substrate by using the first mask pattern in an etching depth that is different from an etching depth of step 5), wherein a groove pattern formed by etching of step 5) and a groove pattern formed by etching of step 7) comprises a linear pattern and a closed figure,

the groove pattern of a linear pattern satisfies the following Relationship Equation 1, and the groove pattern of a closed figure satisfies the following Relationship Equation 2:

[Relationship Equation 1]

$$D \geq 42.9\exp(-\{(P - W)/P\}/0.35) - 1.5$$

wherein D is the depth of the groove pattern. P is a pitch, W is the line width of the groove pattern, and all of units thereof are micrometers,

[Relationship Equation 2]

$$D \geq 33.8\exp(-\{(P - W)/P\}/0.235) + 0.82$$

wherein D is the depth of the groove pattern. P is the pitch, W is the line width of the groove pattern, and all of units thereof are micrometers. In the method of manufacturing the cliché for offset printing according to the present invention, a transparent glass substrate, a plastic film substrate and the like may be used as the substrate, but the substrate is not limited thereto.

In the method of manufacturing the cliché for offset printing according to the present invention, it is preferable that the first mask pattern and the second mask pattern comprise a material that has excellent adhesion strength to the substrate and does not etch the first mask pattern when the second mask pattern is formed.

To be more specific, the first mask pattern may comprise one or more selected from the group consisting of chrome, nickel, oxides thereof, and nitrides thereof, and the second mask pattern may comprise one or more selected from the group consisting of molybdenum and molybdenum oxide.

In the method of manufacturing the cliché for offset printing according to the present invention, the etching process of the substrate may adopt a method known in the art, and more specifically, a wet etching process using a HF solution and the like may be used, but the process is not limited thereto.

In order to solve the aforementioned problems, the present invention is characterized in that the cliché is manufactured by a double etching process applying a known method of manufacturing a single etching cliché. To this end, in the present invention, a double patterning process comprising an align process is introduced and a deep region and a shallow region are continuously etched while wet etching is performed.

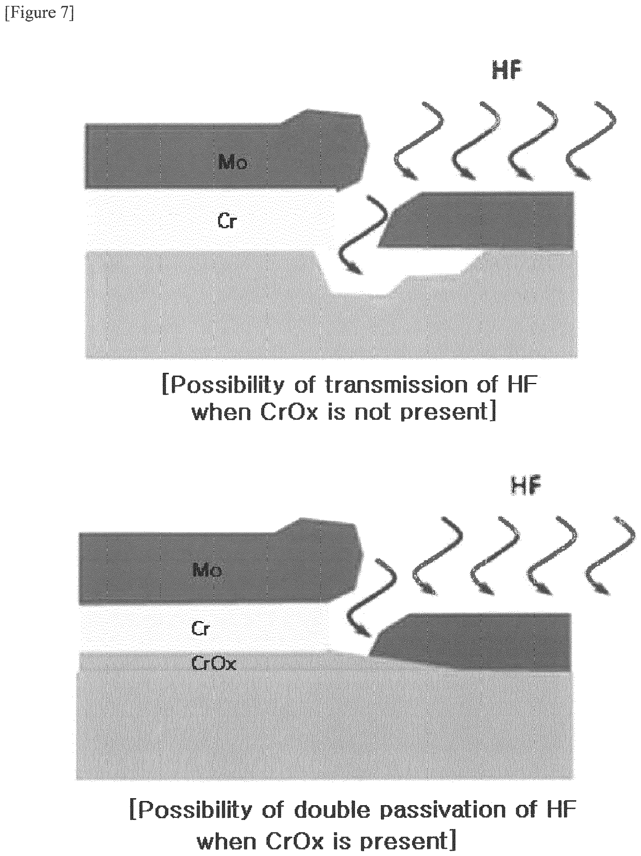

To be more specific, in the present invention, patterning of the entire figure region (comprising the align key for second exposure) is firstly performed on glass on which CrOx/Cr is deposited to pattern CrOx/Cr (CrOx/Cr etching and PR stripping are performed), and, thereafter, Mo is deposited on the entire surface thereof. In this case, the reason why the double layer of CrOx/Cr is used is because since a stack coverage of the subsequently deposited material (Mo) is nonuniformly formed due to a high taper angle of Cr to allow a hydrofluoric acid solution to be transmitted through cracks when first HF etching is performed, in order to prevent this, it is preferable to introduce CrOx having a relatively lower taper angle and lower etching rate as compared to Cr to form a tail. FIG. 7 is a view showing a relative difference in transmission by HF in the case where only Cr is present and in the case where CrOx is present.

After the patterning process of CrOx/Cr, opening (method such as shadow masking) of the first patterned align key region is performed. Thereafter, after the photoresist is applied again on glass on which Mo is secondly deposited, patterning of Mo is performed with regard to the regions having different etching depths, and a first master cliché manufactured by using this method is provided to a glass etching process. In the glass etching process, the first etching process is performed through optimization of a HF concentration and a temperature in order to basically perform etching in a large etching depth. Thereafter, after the photoresist and Mo are removed, the etching process may be performed in order to implement a second small glass etching depth.

The reason why the process is feasible is because CrOx/Cr is not firstly etched by a Mo etchant, and in this etching, the case of combination of metals having selectivity may be easily applied to the present process.

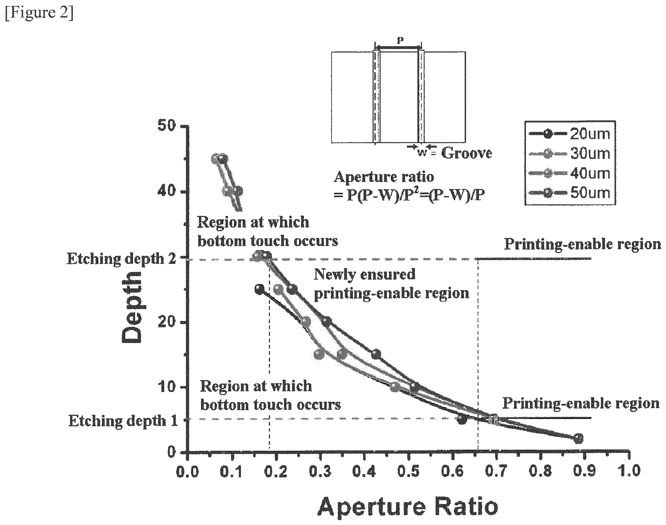

In the present invention, a bottom touch region is confirmed through the following method in order to ensure a more precise etching depth when single etching and double etching of the cliché are performed. Firstly, in order to confirm the bottom touch phenomenon to a linear pattern arranged in parallel to a printing direction when the single etching is performed, the relationship of the aperture ratio (the groove is defined by the line width) obtained by the line width and the pitch and the etching depth with regard to various etching depths is confirmed for each printing pressure. As a result, as shown in FIG. 2, it can be confirmed that the relationship does not largely depend on printing pressure but the bottom touch region is largely changed according to the aperture ratio. In this case, in the case where the aperture ratio is defined through the line width and the pitch of the change graph, the printing-enable region may be represented by the following Relationship Equation 1.

[Relationship Equation 1]

$$D \geq 42.9\exp(-\{(P - W)/P\}/0.35) - 1.5$$

In Relationship Equation 1, D is the etching depth, P is the pitch, W is the line width of the pattern, and all of units thereof are micrometers.

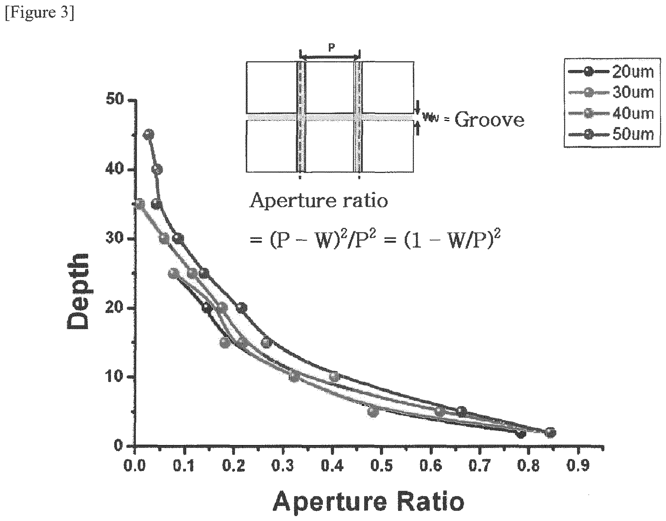

Further, in the present invention, the same experiment is performed with regard to the closed figures such as mesh and square patterns instead of the aforementioned two-dimensional linear pattern. As a result, the graph like FIG. 3 can be obtained, and in this case, in the change graph, in the case where the aperture ratio is defined through the line width and the pitch, the printing-enable region may be represented by the following Relationship Equation 2.

[Relationship Equation 2]

$$D \geq 33.8\exp(-\{(P - W)/P\}/0.235) + 0.82$$

In Relationship Equation 2, D is the etching depth, P is the pitch, W is the line width of the pattern, and all of units thereof are micrometers.

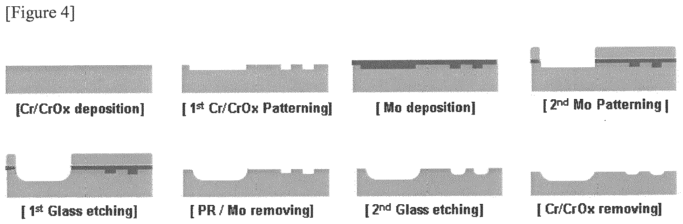

Accordingly, in the case where the region not satisfying the Relationship Equation in a predetermined etching depth needs to be patterned, a method of further ensuring a printing-enable region through redefinition of the etching depth D corresponding to the aforementioned region is recognized as an effective method, and in order to form this, a double etching cliché is manufactured through the method of FIG. 4, and in this case, it can be confirmed that a new printing-enable region like a dotted line of FIG. 2 can be ensured.

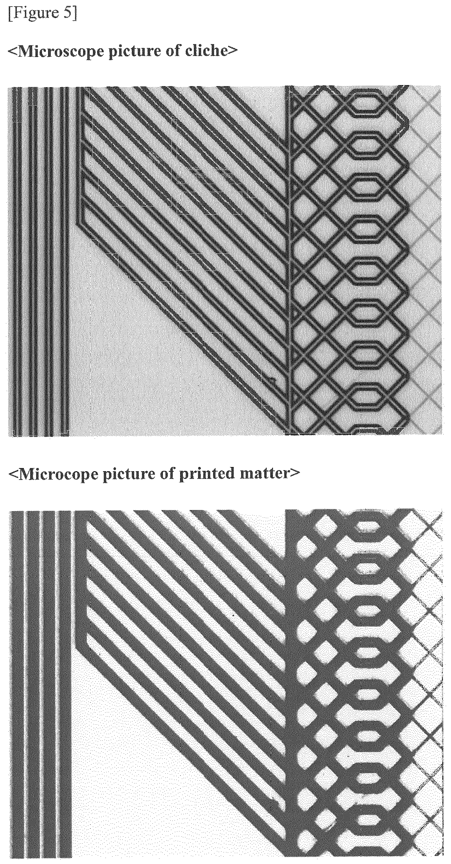

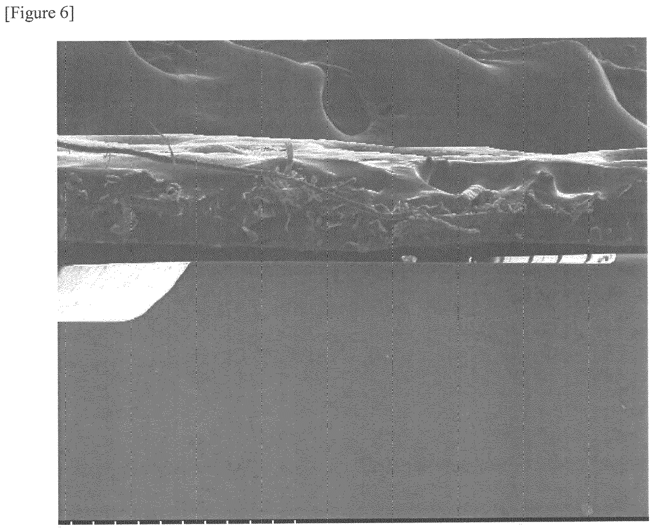

FIG. 5 shows a microscope picture of the cliché for offset printing according to the exemplary embodiment of the present invention and a printed matter using the same, and FIG. 6 shows a SEM picture of a cross-section of the cliché for offset printing according to the exemplary embodiment of the present invention.

As described above, the present invention may comprise a double etching process when a cliché for offset printing is manufactured to control a bottom touch phenomenon that is a problem exhibited when a known wide line width is implemented, thus manufacturing the cliché for offset printing having various line widths and etching depths.

Further, provided is a printed matter printed by using the cliché for offset printing.

The printed matter may comprise at least two patterns having different line widths, and a difference between the line widths of at least two patterns may be 15 $\mu$m or more.

Further, provided is a touch panel comprising the printed matter.

The touch panel may adopt materials and manufacturing methods known in the art, except that the printed matter printed by using the cliché for offset printing according to the present invention is comprised.

**Claims**

1. A cliché for offset printing comprising:

   a groove pattern,
   wherein a depth of at least a partial region of the groove pattern is different from a depth of a residual region,
   the cliché for offset printing comprises the groove pattern of a linear pattern and the groove pattern of a closed figure,
   the groove pattern of a linear pattern satisfies the following Relationship Equation 1, and the groove pattern of a closed figure satisfies the following Relationship Equation 2:

   [Relationship Equation 1]

   $$D \geq 42.9\exp(-\{(P - W)/P\}/0.35) - 1.5$$

   wherein D is the depth of the groove pattern, P is a pitch, W is the line width of the groove pattern, and all of units thereof are micrometers,

   [Relationship Equation 2]

   $$D \geq 33.8\exp(-\{(P - W)/P\}/0.235) + 0.82$$

wherein D is the depth of the groove pattern, P is the pitch, W is the line width of the groove pattern, and all of units thereof are micrometers.

2. The cliché for offset printing of claim 1, wherein the regions having different depths of the groove pattern comprise regions having different line widths of the groove pattern.

3. The cliché for offset printing of claim 2, wherein the region having the relatively larger line width of the groove pattern comprises the region having the larger depth as compared to the region having the relatively smaller line width.

4. The cliché for offset printing of claim 1, wherein the groove pattern comprises at least two patterns having different line widths, and a difference between the line widths of at least two patterns is 15 $\mu$m or more.

5. The cliché for offset printing of claim 4, wherein at least two patterns where the difference between the line widths is 15 $\mu$m or more are connected to each other.

6. The cliché for offset printing of claim 1, wherein the groove pattern comprises two or more patterns where the difference between the line widths is 15 $\mu$m or more.

7. The cliché for offset printing of claim 6, wherein the groove pattern further comprises a pattern having the line width that is different from the minimum line width by 500 $\mu$m or more.

8. A method of manufacturing a cliché for offset printing, comprising:

   1) forming a first mask pattern on a substrate,
   2) forming a second mask pattern on the substrate and the first mask pattern,
   3) etching the substrate by using the second mask pattern,
   4) removing the second mask pattern, and
   5) etching the substrate by using the first mask pattern in an etching depth that is different from an etching depth of step 3), wherein a groove pattern formed by etching of step 3) and a groove pattern formed by etching of step 5) comprises a linear pattern and a closed figure,

   the groove pattern of a linear pattern satisfies the following Relationship Equation 1, and the groove pattern of a closed figure satisfies the following Relationship Equation 2:

[Relationship Equation 1]

$$D \geq 42.9\exp(-\{(P - W)/P\}/0.35) - 1.5$$

wherein D is the depth of the groove pattern, P is a pitch, W is the line width of the groove pattern, and all of units thereof are micrometers,

[Relationship Equation 2]

$$D \geq 33.8\exp(-\{(P - W)/P\}/0.235) + 0.82$$

wherein D is the depth of the groove pattern, P is the pitch, W is the line width of the groove pattern, and all of units thereof are micrometers.

9. The method of manufacturing a cliché for offset printing of claim 8, wherein the first mask pattern comprises one or more selected from the group consisting of chrome, nickel, oxides thereof, and nitrides thereof, and the second mask pattern comprises one or more selected from the group consisting of molybdenum and molybdenum oxide.

10. A method of manufacturing a cliché for offset printing, comprising:

   1) forming a first mask pattern on a substrate,
   2) forming a front surface layer for a second mask pattern on the substrate and the first mask pattern,
   3) forming a third mask pattern on the front surface layer for the second mask pattern,
   4) forming the second mask pattern by using the third mask pattern,
   5) etching the substrate by using the second mask pattern,
   6) removing the second mask pattern, and
   7) etching the substrate by using the first mask pattern in an etching depth that is different from an etching depth of step 5),

   wherein a groove pattern formed by etching of step 5) and a groove pattern formed by etching of step 7) comprises a linear pattern and a closed figure, the groove pattern of a linear pattern satisfies the following Relationship Equation 1, and the groove pattern of a closed figure satisfies the following Relationship Equation 2:

[Relationship Equation 1]

$$D \geq 42.9\exp(-\{(P - W)/P\}/0.35) - 1.5$$

wherein D is the depth of the groove pattern, P is a pitch, W is the line width of the groove pattern, and all of units thereof are micrometers,

[Relationship Equation 2]

$$D \geq 33.8\exp(-\{(P - W)/P\}/0.235) + 0.82$$

wherein D is the depth of the groove pattern, P is the pitch, W is the line width of the groove pattern, and all of units thereof are micrometers.

11. The method of manufacturing a cliché for offset printing of claim 10, wherein the first mask pattern comprises one or more selected from the group consisting of chrome, nickel, oxides thereof, and nitrides thereof, and the second mask pattern comprises one or more selected from the group consisting of molybdenum and molybdenum oxide.

12. The method of manufacturing a cliché for offset printing of claim 10, wherein the first mask pattern comprises a layer of Cr/oxide of Cr or a layer of Cr/nitride of Cr.

13. The method of manufacturing a cliché for offset printing of claim 10, wherein the third mask pattern is a photoresist pattern.

**Patentansprüche**

1. Klischee für Offsetdruck, umfassend:

ein Rillenmuster,
wobei eine Tiefe von zumindest einem Teilbereich des Rillenmusters von einer Tiefe im Restbereich verschieden ist,
das Klischee für Offsetdruck das Rillenmuster eines linearen Musters und das Rillenmuster einer geschlossenen Figur umfasst,
wobei das Rillenmuster eines linearen Musters die folgende Beziehungsgleichung 1 und das Rillenmuster einer geschlossenen Figur die folgende Beziehungsgleichung 2 erfüllt:

[Beziehungsgleichung 1]

$$D \geq 42,9\exp(-\{(P - W)/P\}/0,35) -1,5$$

wobei D die Tiefe des Rillenmusters ist, P eine Teilung ist, W die Zeilenbreite des Rillenmusters ist, und alle Einheiten davon Mikrometer sind,

[Beziehungsgleichung 2]

$$D \geq 33,8\exp(-\{(P - W)/P\}/0,235) + 0,82$$

wobei D die Tiefe des Rillenmusters ist, P die Teilung ist, W die Zeilenbreite des Rillenmusters ist, und alle Einheiten davon Mikrometer sind.

2. Klischee für Offsetdruck nach Anspruch 1, wobei die Bereiche, die verschiedene Tiefen des Rillenmusters aufweisen, Bereiche umfassen, die verschiedene Zeilenbreiten des Rillenmusters aufweisen.

3. Klischee für Offsetdruck nach Anspruch 2, wobei der Bereich mit der relativ größeren Zeilenbreite des Rillenmusters den Bereich mit der größeren Tiefe im Vergleich mit dem Bereich aufweist, der die relativ kleinere Zeilenbreite hat.

4. Klischee für Offsetdruck nach Anspruch 1, wobei das Rillenmuster zumindest zwei Muster mit verschiedenen Zeilenbreiten umfasst, und eine Differenz zwischen den Zeilenbreiten der zumindest zwei Muster 15 $\mu$m oder mehr beträgt.

5. Klischee für Offsetdruck nach Anspruch 4, wobei zumindest zwei Muster, wo die Differenz zwischen den Zeilenbreiten 15 $\mu$m oder mehr beträgt, miteinander verbunden sind.

6. Klischee für Offsetdruck nach Anspruch 1, wobei das Rillenmuster zwei oder mehr Muster umfasst, wo die Differenz zwischen den Zeilenbreiten 15 $\mu$m oder mehr beträgt.

7. Klischee für Offsetdruck nach Anspruch 6, wobei das Rillenmuster ferner ein Muster umfasst, welches die Zeilenbreite aufweist, die von der minimalen Zeilenbreite um 500 $\mu$m oder mehr verschieden ist.

8. Verfahren zur Herstellung eines Klischees für Offsetdruck, umfassend:

1) Formen eines ersten Maskenmusters auf einem Substrat,
2) Formen eines zweiten Maskenmusters auf dem Substrat und dem ersten Maskenmuster,
3) Ätzen des Substrats unter Verwendung des zweiten Maskenmusters,
4) Entfernen des zweiten Maskenmusters, und
5) Ätzen des Substrats unter Verwendung des ersten Maskenmusters in einer Ätztiefe, die von einer Ätztiefe von Schritt 3) verschieden ist,

wobei ein Rillenmuster, das durch Ätzen von Schritt 3) geformt wurde, und ein Rillenmuster, das durch Ätzen von Schritt 5) geformt wurde, ein lineares Muster und eine geschlossene Figur umfasst, das Rillenmuster eines linearen Musters die folgende Beziehungsgleichung 1, und das Rillenmuster einer geschlossenen Figur die folgende Beziehungsgleichung 2 erfüllt:

[Beziehungsgleichung 1]

$$D \geq 42{,}9\exp(-\{(P - W)/P\}/0{,}35) -1{,}5$$

wobei D die Tiefe des Rillenmusters ist, P eine Teilung ist, W die Zeilenbreite des Rillenmusters ist, und alle Einheiten davon Mikrometer sind,

[Beziehungsgleichung 2]

$$D \geq 33{,}8\exp(-\{(P - W)/P\}/0{,}235) + 0{,}82$$

wobei D die Tiefe des Rillenmusters ist, P die Teilung ist, W die Zeilenbreite des Rillenmusters ist, und alle Einheiten davon Mikrometer sind.

9. Verfahren zur Herstellung eines Klischees für Offsetdruck nach Anspruch 8, wobei das erste Maskenmuster eines oder mehrere umfasst, die aus der Gruppe selektiert wurden, die aus Chrom, Nickel, Oxiden davon, und Nitriden davon besteht, und das zweite Maskenmuster eines oder mehrere umfasst, die aus der Gruppe selektiert wurden, die aus Molybdän und Molybdänoxid besteht.

10. Verfahren zur Herstellung eines Klischees für Offsetdruck, umfassend:

1) Formen eines ersten Maskenmusters auf einem Substrat,
2) Formen einer vorderen Oberflächenschicht für ein zweites Maskenmuster auf dem Substrat und dem ersten Maskenmuster,
3) Formen eines dritten Maskenmusters auf der vorderen Oberflächenschicht für das zweite Maskenmuster,
4) Formen des zweiten Maskenmusters unter Verwendung des dritten Maskenmusters,
5) Ätzen des Substrats unter Verwendung des zweiten Maskenmusters,
6) Entfernen des zweiten Maskenmusters, und
7) Ätzen des Substrats unter Verwendung des ersten Maskenmusters in einer Ätztiefe, die von einer Ätztiefe von Schritt 5) verschieden ist,

wobei ein Rillenmuster, das durch Ätzen von Schritt 5) geformt wurde und ein Rillenmuster, das durch Ätzen von Schritt 7) geformt wurde, ein lineares Muster und eine geschlossene Figur umfasst, das Rillenmuster eines linearen Musters die folgende Beziehungsgleichung 1 und das Rillenmuster einer geschlossenen Figur die folgende Beziehungsgleichung 2 erfüllt:

[Beziehungsgleichung 1]

$$D \geq 42{,}9\exp(-\{(P - W)/P\}/0{,}35) -1{,}5$$

wobei D die Tiefe des Rillenmusters ist, P eine Teilung ist, W die Zeilenbreite des Rillenmusters ist, und alle Einheiten davon Mikrometer sind,

[Beziehungsgleichung 2]

$$D \geq 33{,}8\exp(-\{(P - W)/P\}/0{,}235) + 0{,}82$$

wobei D die Tiefe des Rillenmusters ist, P die Teilung ist, W die Zeilenbreite des Rillenmusters ist, und alle Einheiten davon Mikrometer sind.

11. Verfahren zur Herstellung eines Klischees für Offsetdruck nach Anspruch 10, wobei das erste Maskenmuster eines oder mehrere umfasst, die aus der Gruppe selektiert wurden, die aus Chrom, Nickel, Oxiden davon, und Nitriden davon besteht, und das zweite Maskenmuster eines oder mehrere umfasst, die aus der Gruppe selektiert wurden, die aus Molybdän und Molybdänoxid besteht.

12. Verfahren zur Herstellung eines Klischees für Offsetdruck nach Anspruch 10, wobei das erste Maskenmuster eine Schicht aus Cr/Oxid von Cr oder eine Schicht aus Cr/Nitrid von Cr umfasst.

13. Verfahren zur Herstellung eines Klischees für Offsetdruck nach Anspruch 10, wobei das dritte Maskenmuster ein Fotolackmuster ist.

**Revendications**

1. Une plaque d'impression offset composée des éléments suivants :

un motif rainuré, dont la profondeur d'au moins une région partielle du motif rainuré est différente d'une profondeur d'une région résiduelle, la plaque d'impression offset se compose du motif rainuré d'un motif linéaire et du motif rainuré d'une figure fermée, le motif rainuré d'un motif linéaire respecte l'équation de rapport 1 suivante alors que le motif rainuré d'une figure fermée respecte l'équation de rapport 2 suivante :

[Équation de rapport 1]

$$D \geq 42{,}9\exp(-\{(P - W)/P\}/0{,}35) - 1{,}5$$

où D est la profondeur du motif rainuré, P est le pas, W est la largeur de la ligne du motif rainuré et toutes les unités sont des micromètres

[Équation de rapport 2]

$$D \geq 33{,}8\exp(-\{(P - W)/P\}/0{,}235) + 0{,}82$$

où D est la profondeur du motif rainuré, P est le pas, W est la largeur de la ligne du motif rainuré et toutes les unités sont des micromètres.

2. La plaque d'impression offset que décrit la revendication 1, si ce n'est que les régions qui ont des profondeurs différentes pour le motif rainuré englobent les régions qui ont des largeurs de lignes différentes pour le motif rainuré.

3. La plaque d'impression offset que décrit la revendication 2, si ce n'est que la région qui a la largeur de ligne relativement plus importante pour le motif rainuré englobe la région qui a la profondeur plus importante, par rapport à la région qui a la largeur de ligne relativement plus petite.

4. La plaque d'impression offset que décrit la revendication 1, si ce n'est que le motif rainuré comporte au moins deux motifs qui ont des largeurs différentes de lignes et que la différence entre les largeurs de lignes d'au moins deux motifs est égale ou supérieure à 15 μm.

5. La plaque d'impression offset que décrit la revendication 4, si ce n'est qu'au moins deux motifs dont la différence entre les largeurs de lignes est égale ou supérieure à 15 μm sont reliés l'un à l'autre.

6. La plaque d'impression offset que décrit la revendication 1, si ce n'est que le motif rainuré comporte au moins deux motifs dont la différence entre les largeurs de lignes est égale à au moins 15 μm.

7. La plaque d'impression offset que décrit la revendication 6, si ce n'est que le motif rainuré comporte en outre un motif dont la largeur de ligne diffère d'au moins 500 μm de la largeur minimale de ligne.

8. Un procédé de fabrication d'une plaque d'impression offset composé des éléments suivants :

   1) formation d'un premier motif de type masque sur une surface de base,

2) formation d'un deuxième motif de type masque sur la surface de base et le premier motif de type masque,
3) gravure de la surface de base en utilisant le deuxième motif de type masque,
4) retrait du deuxième motif de type masque et
5) gravure de la surface de base en utilisant le premier motif de type masque à une profondeur de gravure différente de la profondeur de gravure indiquée à l'alinéa 3,

et si ce n'est qu'un motif rainuré obtenu par la gravure décrite à l'alinéa 3) et un motif rainuré obtenu par la gravure décrite à l'alinéa 5) se composent d'un motif linéaire et d'une figure fermée, le motif rainuré d'un motif linéaire respecte l'équation de rapport 1 suivante alors que le motif rainuré d'une figure fermée respecte l'équation de rapport 2 suivante :

[Équation de rapport 1]

$$D \geq 42{,}9\exp(-\{(P - W)/P\}/0{,}35) - 1{,}5$$

où D est la profondeur du motif rainuré, P est le pas, W est la largeur de la ligne du motif rainuré et toutes les unités sont des micromètres

[Équation de rapport 2]

$$D \geq 33{,}8\exp(-\{(P - W)/P\}/0{,}235) + 0{,}82$$

où D est la profondeur du motif rainuré, P est le pas, W est la largeur de la ligne du motif rainuré et toutes les unités sont des micromètres.

9. Le procédé de fabrication d'une plaque d'impression offset que décrit la revendication 8, si ce n'est que le premier motif du type masque se compose d'au moins l'un des matériaux sélectionnés dans le groupe suivant : chrome, nickel et oxydes de ces métaux et nitrures de ces métaux, et que le deuxième motif du type masque se compose d'au moins l'un des matériaux sélectionnés dans le groupe suivant : molybdène et oxyde de molybdène.

10. Un procédé de fabrication d'une plaque d'impression offset composé des éléments suivants :

   1) formation d'un premier motif de type masque sur une surface de base,
   2) formation d'une couche sur la surface avant pour un deuxième motif du type masque sur la surface de base et le premier motif de type masque,
   3) formation d'un troisième motif de type masque sur la surface avant pour le deuxième motif de type masque,

4) formation du deuxième motif de type masque en utilisant le troisième motif de type masque,

5) gravure de la surface de base en utilisant le deuxième motif de type masque,

6) retrait du deuxième motif de type masque et

7) gravure de la surface de base en utilisant le premier motif de type masque à une profondeur de gravure différente de la profondeur de gravure indiquée à l'alinéa 5,

et si ce n'est qu'un motif rainuré obtenu par la gravure décrite à l'alinéa 5) et un motif rainuré obtenu par la gravure décrite à l'alinéa 7) se composent d'un motif linéaire et d'une figure fermée, le motif rainuré d'un motif linéaire respecte l'équation de rapport 1 suivante alors que le motif rainuré d'une figure fermée respecte l'équation de rapport 2 suivante :

[Équation de rapport 1]

$$D \geq 42{,}9\exp(-\{(P - W)/P\}/0{,}35) - 1{,}5$$

où D est la profondeur du motif rainuré, P est le pas, W est la largeur de la ligne du motif rainuré et toutes les unités sont des micromètres

[Équation de rapport 2]

$$D \geq 33{,}8\exp(-\{(P - W)/P\}/0{,}235) + 0{,}82$$

où D est la profondeur du motif rainuré, P est le pas, W est la largeur de la ligne du motif rainuré et toutes les unités sont des micromètres.

11. Le procédé de fabrication d'une plaque d'impression offset que décrit la revendication 10, si ce n'est que le premier motif du type masque se compose d'au moins l'un des matériaux sélectionnés dans le groupe suivant : chrome, nickel et oxydes de ces métaux et nitrures de ces métaux, et que le deuxième motif du type masque se compose d'au moins l'un des matériaux sélectionnés dans le groupe suivant : molybdène et oxyde de molybdène.

12. Le procédé de fabrication d'une plaque d'impression offset que décrit la revendication 10, si ce n'est que le premier motif de type masque comporte une couche de Cr/oxyde de Cr ou une couche de Cr/nitrure de Cr.

13. Le procédé de fabrication d'une plaque d'impression offset que décrit la revendication 10, si ce n'est que le troisième motif de type masque est un motif à ré-

sine photosensible.

[Figure 1]

$$W = 2D + W_0 + a$$

[Figure 2]

[Figure 3]

[Figure 4]

[Cr/CrOx deposition]    [ 1st Cr/CrOx Patterning]    [ Mo deposition]    [ 2nd Mo Patterning ]

[ 1st Glass etching]    [ PR / Mo removing]    [ 2nd Glass etching]    [ Cr/CrOx removing]

[Figure 5]

<Microscope picture of cliche>

<Microcope picture of printed matter>

[Figure 6]

[Figure 7]

[Possibility of transmission of HF
when CrOx is not present]

[Possibility of double passivation of HF
when CrOx is present]

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 20110069459
- US 20110132527 A
- US 20050243233 A